(19)

Europäisches
Patentamt
European
Patent Office
Office européen
des brevets

(11)     **EP 2 662 865 A1**

(12)                          **EUROPEAN PATENT APPLICATION**
                          published in accordance with Art. 153(4) EPC

(43) Date of publication:
     **13.11.2013 Bulletin 2013/46**

(21) Application number: **11854618.3**

(22) Date of filing: **28.11.2011**

(51) Int Cl.:
*H01B 5/14* (2006.01)          *B32B 15/08* (2006.01)
*H01L 51/42* (2006.01)          *H01L 51/50* (2006.01)
*H05B 33/28* (2006.01)

(86) International application number:
     **PCT/JP2011/077435**

(87) International publication number:
     **WO 2012/093530 (12.07.2012 Gazette 2012/28)**

(84) Designated Contracting States:
     **AL AT BE BG CH CY CZ DE DK EE ES FI FR GB
     GR HR HU IE IS IT LI LT LU LV MC MK MT NL NO
     PL PT RO RS SE SI SK SM TR**

(30) Priority: **06.01.2011 JP 2011001495**

(71) Applicant: **LINTEC Corporation
     Tokyo 173-0001 (JP)**

(72) Inventors:
     • **MUTO, Tsuyoshi
       Tokyo 173-0001 (JP)**

     • **NAGAMOTO, Koichi
       Tokyo 173-0001 (JP)**
     • **KATO, Kunihisa
       Tokyo 173-0001 (JP)**

(74) Representative: **Gille Hrabal
     Patentanwälte
     Brucknerstrasse 20
     40593 Düsseldorf (DE)**

(54)     **TRANSPARENT CONDUCTIVE LAMINATE BODY AND ORGANIC THIN FILM DEVICE**

(57)     A problem is to provide a transparent conductive laminate body that has a low surface resistivity and an organic thin film device using the laminate body, and the problem is solved by a transparent conductive laminate body having a transparent substrate having laminated directly on at least one surface thereof in this order a conductive metal pattern layer and a conductive organic layer having a conductive organic polymer compound, a material for forming the conductive metal pattern layer being at least one metal selected from gold, silver, copper and platinum, or an alloy having the metal, and an organic thin film device using the same.

EP 2 662 865 A1

**Description**

Technical Field

The present invention relates to a transparent conductive laminate body and an organic thin film device. More specifically, the present invention relates to a transparent conductive laminate body that has conductivity capable of being applied to an electrode for an organic device, has a high total luminous transmittance, and is inexpensive, and an organic thin film device using the same.

Background Art

In recent years, a transparent electrode using a transparent conductive film is being actively investigated for organic electroluminescence, various solar cells, touch-sensitive panels, mobile phones, electronic paper and the like. For example, an organic photoelectric conversion or electrophoto conversion device, which is typified by an organic thin film solar cell, is generally produced by laminating materials on an electrode formed of a transparent conductive film. As the transparent conductive film, various conductive films, such as a metal thin film, a metal oxide thin film and a conductive nitride thin film, have been investigated, and a metal oxide thin film is currently used mainly since a metal oxide thin film may achieve both light transmission and conductivity, and it may have excellent durability. In particular, indium oxide doped with tin (which is hereinafter referred to as ITO) is being commonly used since ITO is well balanced between light transmission and conductivity, and it easily forms an electrode fine pattern through wet etching with an acid solution (see, for example, Patent Documents 1 and 2) . However, ITO may have issues on both cost and resource depletion since ITO contains indium as a rare element.
A known material that can be seemingly considered as a transparent conductive material but contains no rare element includes a sheet containing a transparent substrate, such as PET, having formed thereon a metallic fine pattern or grid. The sheet may be controlled in light transmission and conductivity depending upon the design of the pattern (e.g., the aperture ratio of the aperture, which is defined by the pitch and the line width), and thus may be possibly used as a transparent electrode.
As such the conductive laminate body, for example, a transparent conductive film is disclosed (see Patent Document 3) that has a thin line structure containing a conductive metal and a conductive film containing light transmissive conductive fine particles. In consideration of application to an organic thin film solar cell, however, the method may include a problem on light transmittance since the conductive film contains conductive fine particles.
A method of providing a metal line structure having a mesh pattern on a transparent electrode layer is proposed (see Patent Document 4). In the method, however, since the conductivity is enhanced by vapor deposition of an ITO film, and thus the method may involve a problem on resource depletion of the material of the ITO film. The method may also involve a problem on the number of process steps and the production cost due to the ITO film formed by vapor deposition. Furthermore, a transparent conductive film is proposed (see Patent Document 5) that contains a transparent substrate sheet having formed on one surface thereof a conductive metal mesh layer and a transparent conductive layer formed of a conductive polymer layer, in which the metal of the conductive metal mesh layer is a base metal or an alloy containing a base metal. However, the film may include a problem on durability due to the use of a base metal or an alloy containing a base metal.
Moreover, a transparent conductive film is proposed (see Patent Document 6) that contains a transparent support having thereon a mesh conductive layer formed with at least one metal, in which a transparent conductive layer containing a migration preventing agent is provided on the conductive layer. However, the film may include a problem that the use of a compound capable of being bonded to a metal ion, such as a benzotriazole compound and a triazine compound, as the migration preventing agent increases the surface resistance, which lowers the conductivity and the light transmittance.

Related Art Documents

Patent Documents

Patent Document 1: WO2005/041216
Patent Document 2: JP-A-2008-204683
Patent Document 3: JP-A-2008-288102
Patent Document 4: JP-A-2005-302508
Patent Document 5: JP-A-2009-81104

Patent Document 6: JP-A-2009-146678

Summary of the Invention

Problems to be solved by the Invention

The present invention has been made in view of the aforementioned problems, and an object thereof is to solve the problems and to provide, without the use of ITO, a transparent conductive laminate body that has conductivity capable of being applied to an electrode for an organic device, has a high total luminous transmittance, and is inexpensive, and an organic thin film device using the same.

Means for solving the Problems

As a result of earnest investigations made by the present inventors for solving the problems, it has been found that a transparent conductive laminate body that has conductivity capable of being applied to an electrode for an organic device, has a high total luminous transmittance and is inexpensive, may be provided without the use of ITO by forming a conductive metal pattern layer and a conductive organic layer containing a conductive organic polymer compound on at least one surface of a transparent substrate. It has been also found that the transparent conductive laminate body has conductivity capable of being applied to various organic thin film devices and a high total luminous transmittance. Thus, the present invention has been completed.

The present invention provides:

(1) a transparent conductive laminate body wherein a conductive metal pattern layer and a conductive organic layer containing a conductive organic polymer compound are in this order laminated directly on at least one surface of a transparent substrate, characterized in that a material for forming the conductive metal pattern layer is at least one metal selected from gold, silver, copper and platinum, or an alloy containing the metal,

(2) the transparent conductive laminate body according to the item (1), wherein the conductive organic polymer compound is at least one selected from a polyaniline, a polypyrrole, a polythiophene, and derivatives thereof,

(3) the transparent conductive laminate body according to the item (1) or (2), wherein the conductive metal pattern layer has a shape, as viewed from a surface thereof, that has a continuous outer frame,

(4) the transparent conductive laminate body according to the item (3), wherein the outer frame is partly cut off, and

(5) an organic thin film device comprising the transparent conductive laminate body according to any one of the items (1) to (4).

Effects by the Invention

According to the present invention, a transparent conductive laminate body that has conductivity capable of being applied to an electrode for an organic device, has a high total luminous transmittance and is inexpensive, and an organic thin film device may be provided without the use of ITO.

Brief Description of the Drawings

Fig. 1 is a schematic illustration showing a cross section of a transparent conductive laminate body of the present invention.

Fig. 2 is schematic illustrations showing various shapes of a conductive metal pattern layer in a transparent conductive laminate body of the present invention.

Fig. 3 is schematic illustrations, in which (a) shows a conductive metal pattern layer having a continuous outer frame over the entire circumference, and (b) and (c) show conductive metal pattern layers each having a continuous outer frame that is partly cut off in a transparent conductive laminate body of the present invention.

Fig. 4 is a schematic illustration showing a cross section of an organic thin film device containing a transparent conductive laminate body of the present invention having laminated thereon a photoelectric conversion layer and an electrode.

Fig. 5 is a schematic illustration showing a positional relationship in the horizontal direction, as viewed from an upper surface of an organic thin film device of the present invention, between an electrode and a conductive metal pattern layer having a continuous outer frame that is partly cut off.

Embodiments for Carrying Out the Invention

Embodiments of the present invention will be described in detail below with reference to the drawings.
The transparent conductive laminate body of the present invention contains a transparent substrate having at least one surface thereof a conductive metal pattern layer and a conductive organic layer containing a conductive organic polymer compound, and does not contain an ITO layer contained in a conventional transparent conductive film.

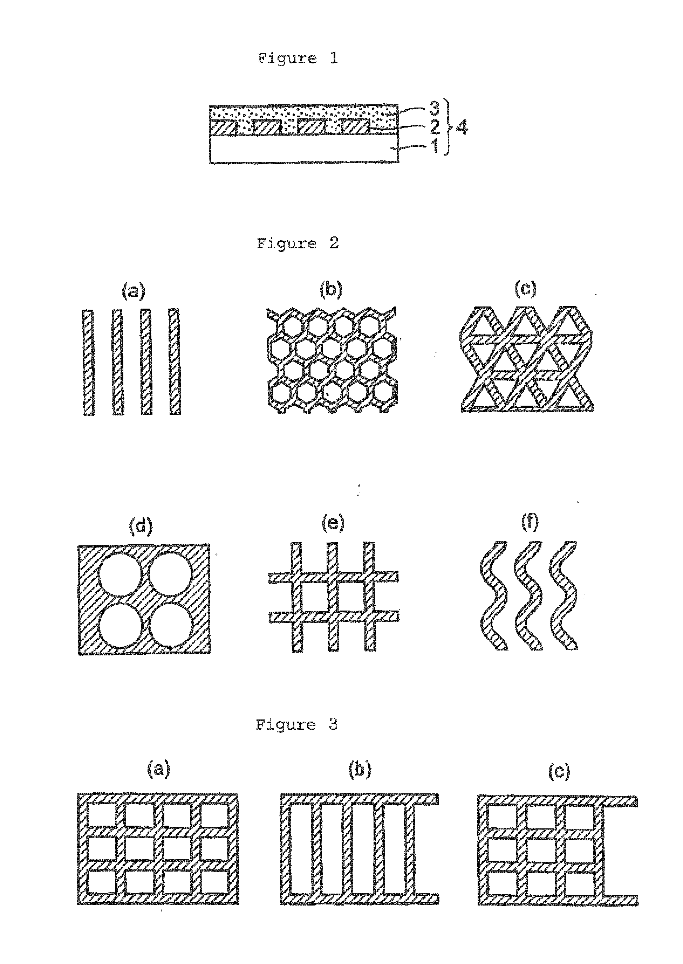

Fig. 1 is a schematic illustration showing a cross section of a transparent conductive laminate body of the present invention. Numerals in Fig. 1 are as follows. 1 denotes a transparent substrate, 2 denotes a conductive metal pattern layer, 3 denotes a conductive organic layer, and 4 denotes a transparent conductive laminate body.

[Transparent substrate]

The transparent substrate used preferably has a total luminous transmittance measured according to JIS K7361-1 of 70% or more, more preferably 80% or more, and further preferably 90% or more. As the transparent substrate, glass (plate), a plastic film and the like are generally used, and a plastic film is preferred from the standpoint of flexibility. Examples of the plastic film include plastic films formed of polyethylene terephthalate, polyethylene naphthalate, triacetyl cellulose, syndiotactic polystyrene, polyphenylene sulfide, polycarbonate, polyarylate, polysulfone, polyestersulfone, polyetherimide, cyclic polyolefin and the like. Of those, polyethylene terephthalate, polyethylene naphthalate, polyarylate and the like are preferred as those excellent in mechanical strength, durability and the like. The thickness of the transparent substrate is preferably from 3 $\mu$m to 5 mm, more preferably from 5 $\mu$m to 1 mm, and particularly preferably from 10 $\mu$m to 300 $\mu$m, from the standpoint of the balance among mechanical strength, durability and transparency.

[Conductive metal pattern layer]

In the transparent conductive laminate body of the present invention, the conductive metal pattern layer is provided on at least one surface of the transparent substrate. Examples of the conductive metal pattern layer include a layer having a fine pattern structure of a metal grid pattern, such as an electromagnetic wave shield film of a plasma display. The pattern structure of the conductive metal pattern layer  is not particularly limited, and examples thereof include a stripe form, a linear form, a curved form, a wave form (such as a sine curve form), a mesh form with a rectangular shape (a lattice shape), a mesh form with a polygonal shape, a mesh form with a circular shape, a mesh form with an elliptic shape, and an irregular form. Of those, there is preferred a form having a portion that is surrounded by the lines of the conductive metal pattern layer but does not have the conductive metal pattern layer thereon (i.e., an aperture). The shape of the aperture is not particularly limited, and examples thereof include a rectangular shape (a lattice shape), a polygonal shape, a circular shape and an elliptic shape. Examples of the pattern structure include those shown in Figs. 2(a) to 2(f), i.e., (a) a stripe form, (b) an aperture with a hexagonal shape, (c) an aperture with a triangular shape, (d) an aperture with a circular shape, (e) a mesh form with many apertures with a rectangular shape (a lattice shape) arranged, and (f) a wave form (such as a sine curve form).
In the conductive metal pattern layer, the lines surrounding the aperture may be in a linear form or in a wave form (such as a sine curve form) shown in Fig. 2(f).
As shown in Fig. 3 (a), furthermore, the conductive metal pattern layer preferably has a shape that has an outer peripheral portion formed of a conductive metal layer over the entire circumference surrounding the conductive metal pattern  layer, and in other words, preferably has a shape that has a continuous outer frame (for example, a shape obtained by removing a handle from a grilling mesh) as viewed from the surface of the conductive metal pattern layer.
As shown in Figs. 3 (b) and 3 (c), moreover, the outer frame is preferably partly cut off. With this structure, on applying the transparent conductive laminate body of the present invention to an organic thin film device, the conductive pattern layer may be prevented from causing a short circuit due to contact with an electrode described later.
The thickness of the conductive metal pattern layer is preferably from 20 nm to 100 $\mu$m, particularly from 30 to 1, 000 nm, and further preferably from 40 to 800 nm.
The aperture ratio of the conductive metal pattern layer is preferably 80% or more and less than 100%, more preferably 90% or more and less than 100%, and further preferably 95% or more and less than 100%, from the standpoint of the transparency (total luminous transmittance). The aperture ratio herein means the ratio of the area of the portion where no conductive metal pattern layer is formed (i.e., the aperture).
The pitch of the aperture of the conductive metal pattern layer is preferably from 1 to 3,000 $\mu$m, more preferably from 5 to 2, 000 $\mu$m, and further preferably from 10 to 1, 500 $\mu$m. When the pitch of the aperture is less than 1 $\mu$m, the transparency  may be occasionally decreased, and when it exceeds 3,000 $\mu$m, the conductivity may be decreased.
The line width in the conductive metal pattern layer is preferably from 100 nm to 1,000 $\mu$m, more preferably from 500 nm to 500 $\mu$m, and further preferably from 1 to 100 $\mu$m. When the line width exceeds 1,000 $\mu$m, the aperture ratio may be occasionally decreased to impair the transparency, and when it is less than 100 nm, there is a possibility of failing to provide conductivity. The aperture ratio is obtained as follows.

Aperture ratio (%)

= {(area of aperture)/[(area of lines of conductive metal

pattern layer) + (area of aperture)]} × 100

The present invention is characterized in that the material for forming the conductive metal pattern layer is at least one metal selected from gold, silver, copper and platinum, or an alloy containing the metal. These materials have high corrosion resistance due to the small ionization tendency among metals, and thus are preferred due to the high corrosion resistance to the conductive organic layer described later. These materials are also preferred due to the high conductivity thereof. The use of other materials other than these materials is not preferred since the conductive metal pattern layer formed therewith, on which the conductive organic layer described later is laminated, may be dissolved or corroded, thereby failing to provide conductivity and lowering the transparency.

The alloy is not particularly limited as far as the alloy contains at least one metal selected from gold, silver, copper and platinum as a major component. Examples of the alloy include bronze, phosphor bronze, brass, cupronickel and monel, which may be appropriately selected. Of those, an alloy containing copper as a major component is preferably used due to the excellent conductivity and the good processability thereof.

The conductive metal pattern layer may be a single layer or may have a multilayer structure. The conductive metal pattern layer preferably has a multilayer structure from the standpoint of being capable of enhancing the corrosion resistance while maintaining the conductivity.

The multilayer structure may be a multilayer structure containing laminated layers that are formed of the same material, or a multilayer structure containing laminated layers that are formed of two or more kinds of materials.

A multilayer structure containing laminated layers that are formed of two or more kinds of materials is preferred from the standpoint of being capable of enhancing the corrosion resistance. In the multilayer structure, it is preferred that a pattern layer, containing at least one metal selected from gold, silver, copper and platinum, or an alloy comprising the metal, is formed on the transparent substrate, and a pattern layer containing a material that has higher corrosion resistance than the material forming the pattern layer is laminated thereon.

The multilayer structure is preferably a two-layer structure containing layers formed of different materials laminated. In the multilayer structure, for example, a silver pattern layer may be formed firstly, and then a copper pattern layer, which has higher corrosion resistance than silver, may be formed thereon, thereby enhancing the corrosion resistance while maintaining the high conductivity of silver.

The method of providing the conductive metal pattern layer on the transparent substrate is not particularly limited, and known methods may be appropriately selected. Examples of the method include a method, in which the conductive metal pattern layer is provided in advance and is then adhered on the transparent substrate (which is denoted by numeral 1 in Fig. 1) with an adhesive, a conductive paste or the like, a method, in which a conductive metal layer having no pattern formed (i.e., having no aperture) is provided on the transparent substrate and then processed into the shape of the conductive metal pattern by a known method, such as a mechanical process and a chemical process, and a method, in which the conductive metal pattern is formed directly on the transparent substrate by an ink-jet method, a screen printing method or the like.

Examples of the method of providing the conductive metal layer include a dry process, such as PVD (physical vapor deposition), e.g., vacuum vapor deposition, sputtering and ion plating, and CVD (chemical vapor deposition), e.g., thermal CVD and atomic layer deposition (ALD), a wet process, such as a coating method, e.g., dip coating, spin coating, spray coating, gravure coating, die coating and doctor blade coating, and electrochemical deposition, and a silver salt method, which may be appropriately selected depending on the material of the conductive metal layer.

The conductive metal pattern layer (which is denoted by numeral 2 in Fig. 1) may be formed by subjecting the conductive metal layer, which has been formed on the transparent substrate by the above-described methods, to various known mechanical process, chemical process and the like, such as a photolithography method; a method of printing an etching resist pattern by an ink jet method, a screen printing method or the like and then performing etching; and an imprinting method. The method may be appropriately selected from the aforementioned methods depending on the material of the conductive metal layer and the shape of the pattern.

For enhancing the adhesiveness between the conductive metal pattern layer and the transparent substrate in the present invention, a known easy adhesion layer such as an acrylic resin and polyurethane resin, may be provided between the conductive metal pattern layer and the transparent substrate.

[Conductive organic layer]

The conductive organic layer (which is denoted by numeral 3 in Fig. 1) is a layer that contains a conductive organic polymer compound.

The conductive organic polymer compound used is preferably at least one selected from a polyaniline, a polypyrrole, a polythiophene, and derivatives thereof, which are conductive polymers having conductivity due to $\pi$ electron conjugation, since these materials are excellent in dispersibility, may easily form a coated film as the conductive organic layer, have high transparency, and provide a low surface resistivity and excellent film conductivity as the conductive organic layer.

The polyaniline is a polymer of a compound that is formed by replacing the 2-position, 3-position or N-position of aniline by an alkyl group having from 1 to 18 carbon atoms, an alkoxy group, an aryl group, a sulfonic acid group or the like, and examples thereof include poly-2-methylaniline, poly-3-methylaniline, poly-2-ethylaniline, poly-3-ethylaniline, poly-2-methoxyaniline, poly-3-methoxyaniline, poly-2-ethoxyaniline, poly-3-ethoxyaniline, poly-N-methylaniline, poly-N-propylaniline, poly-N-phenyl-1-naphthylaniline, poly-8-anilino-1-naphthalenesulfonic acid, poly-2-aminobenzenesulfonic acid and poly-7-anilino-4-hydroxy-2-naphthalenesulfonic acid.

The polypyrrole is a polymer of a compound that is formed by replacing the 1-position, 3-position or 4-position of pyrrole by an alkyl group having from 1 to 18 carbon atoms, an alkoxy group or the like, and examples thereof include poly-1-methylpyrrole, poly-3-methylpyrrole, poly-1-ethylpyrrole, poly-3-ethylpyrrole, poly-1-methoxypyrrole, 3-methoxypyrrole, poly-1-ethoxypyrrole and poly-3-ethoxypyrrole.

The polythiophene is a polymer of a compound that is formed by replacing the 3-position or 4-position of thiophene by an alkyl group having from 1 to 18 carbon atoms, an alkoxy group or the like, and examples thereof include such polymers as poly-3-methylthiophene, poly-3-ethylthiophene, poly-3-methoxythiophene, poly-3-ethoxythiophene and poly-3,4-ethylenedioxythiophene (PEDOT).

Examples of the derivatives of a polyaniline, a polypyrrole and a polythiophene include a dopant thereof. Examples of the dopant includes a halide ion, such as a chloride ion, a bromide ion and an iodide ion; a perchlorate ion; a tetrafluoroborate ion; a hexafluoroarsenate ion; a sulfate ion; a nitrate ion; a thiocyanate ion; a tetrafluorosilicate ion; a phosphoric acid ion, such as a phosphate ion, a phenylphosphate ion and tetrafluorophosphate ion; a trifluoroacetate ion; an alkylbenzenesulfonate ion, such as a tosylate ion, an ethybenzenesulfonate ion and a dodecylbenzenesulfonate ion; an alkylsulfonate ion, such as a methylsulfonate ion and an ethylsulfonate ion; and a polymer ion, such as a polyacrylate ion, a polyvinylsulfonate ion, a polystyrenesulfonate ion (PSS) and a poly(2-acrylamido-2-methylpropanesulfonate) ion, which may be used solely or as a combination of two or more kinds thereof.

Of the dopants, a polymer ion is preferred, such as a polyacrylate ion, a polyvinylsulfonate ion, a polystyrenesulfonate ion (PSS) and a poly(2-acrylamido-2-methylpropanesulfonate) ion, which facilitate the control of the high conductivity and have a hydrophilic skeleton that is useful for facilitating the dispersion thereof in a solution, and is more preferably a polystyrenesulfonate ion (PSS), which is a water soluble and strongly acidic polymer.

Among the derivatives of a polyanilin, a polypyrrole and a polythiophene, derivatives of a polythiophene are preferred and, of those, a mixture of poly-3,4-ethyleneoxidethiophene and a polystyrenesulfonate ion as a dopant (which may be hereinafter referred to as PEDOT:PSS), and the like are preferred.

Examples of the method of forming the conductive organic layer include a wet process, such as a coating method, e.g., dip coating, spin coating, spray coating, gravure coating, die coating and doctor blade coating, and electrochemical deposition, which may be appropriately selected.

Of those methods, it is preferred that an aqueous dispersion liquid or solution of the conductive organic polymer compound (i.e., a coating liquid) is coated on the conductive metal pattern layer (which is denoted by numeral 2 in Fig. 1) provided on the transparent substrate 1, by a coating method, such as dip coating, spin coating, spray coating, gravure coating, die coating and doctor blade coating, thereby forming the conductive organic layer. According to the method, the conductive organic layer may be easily formed.

The thickness of the conductive organic layer is preferably from 5 to 1,000 nm, and more preferably from 30 to 300 nm. When the thickness is less than 5 nm, there is a possibility that the vicinity of the aperture of the conductive metal pattern layer 2 having steps may not be completely covered, and when the thickness exceeds 1,000 nm, the transparency may be disadvantageously lowered due to the low total luminous transmittance.

The conductive organic layer may be a single layer or may have a laminated structure containing two or more layers containing different kinds of the conductive organic polymer compounds.

The surface resistivity of the conductive organic layer itself is preferably from 1 to $1.0 \times 10^9$ $\Omega$ per square. When the surface resistivity is in the range, good conductivity may be advantageously obtained on applying to an organic thin film device.

The total luminous transmittance (which is measured according to JIS K7361-1) of the conductive organic layer itself is preferably 80% or more, more preferably 85% or more, and further preferably 90% or more.

The transparent conductive laminate body of the present invention has the conductive metal pattern layer and the conductive organic layer on at least one surface of the transparent substrate and, the conductive metal pattern layer and the conductive organic layer are preferably formed in this order on at least one surface of the transparent substrate as shown in Fig. 1.

Specifically, the transparent conductive laminate body of the present invention preferably has an embodiment, in which the conductive metal pattern layer is formed directly on the transparent substrate, and the conductive organic layer is laminated on the conductive metal pattern layer.

As described above, the transparent conductive laminate body of the present invention has the conductive metal pattern layer and the conductive organic layer in this order on at least one surface of the transparent substrate, thus provides a low surface resistivity and is excellent in conductivity and transparency.

As described above, the transparent conductive laminate body of the present invention has high transparency and high conductivity and is excellent in balance between transparency and conductivity, and thus it can be applied to various organic thin film devices.

The transparent conductive laminate body of the present invention preferably has a surface resistivity of from 1 to $1.0 \times 10^9$ $\Omega$ per square, and more preferably from 1 to $1.0 \times 10^3$ $\Omega$ per square. When the surface resistivity is in the range, the transparent conductive laminate body advantageously has good conductivity on applying to an organic thin film device.

The transparent conductive laminate body preferably has a total luminous transmittance (which is measured according to JIS K7361-1) of 80% or more, more preferably 85% or more, and further preferably 90% or more. When the total luminous transmittance is 80% or more, sufficient transparency may be obtained on applying the transparent conductive laminate body of the present invention to an organic thin film device.

[Organic thin film device]

The organic thin film device of the present invention will be described below.

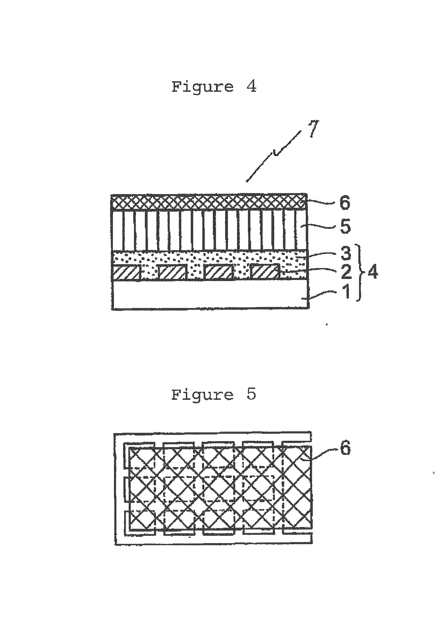

The organic thin film device of the present invention has the transparent conductive laminate body described above (which is denoted by numeral 4 in Fig. 4).

Examples of the organic thin film device include an organic device, such as an organic transistor, an organic memory and an organic EL; a liquid crystal device; electronic paper; a thin film transistor; an electrochromic device; an electrochemical light emitting device; a touch-sensitive panel; a display device; a photoelectric conversion device, such as a solar cell; a thermoelectric conversion device; a piezoelectric conversion device; and a capacitor device.

Fig. 4 is a cross sectional view showing an example of the layer structure of the organic thin film device having the transparent conductive laminate body of the present invention. In Fig. 4, numerals 1 denotes the transparent substrate, 2 denotes the conductive metal pattern layer, 3 denotes the conductive organic layer, 4 denotes the transparent conductive laminate body, 5 denotes a photoelectric conversion layer, 6 denotes an electrode, and 7 denotes an organic thin film device. As an example of the organic thin film device, a photoelectric conversion device will be described below with reference to Fig. 4.

<Photoelectric Conversion Layer>

The photoelectric conversion layer performs photoelectric conversion, and is preferably an organic semiconductor from the standpoint of the cost reduction of raw materials, the flexibility, the moldability, the high absorption constant, the weight saving, the impact resistance and the like.

The photoelectric conversion layer may be constituted by a single layer or plural layers. In the case of a single layer, the photoelectric conversion layer is generally formed of an intrinsic semiconductor (i-type semiconductor) or the like.

In the case of plural layers, laminates (p-type semiconductor layer/n-type semiconductor layer), (p-type semiconductor layer/i-type semiconductor layer/n-type semiconductor layer) and the like may be used.

The thickness of the photoelectric conversion layer is generally preferably from 30 nm to 2 $\mu$m, and particularly preferably from 40 to 300 nm, from the standpoint of the exciton diffusion distance, while depending on whether the photoelectric conversion layer is constituted by the single layer or plural layers.

The organic semiconductors used in the photoelectric conversion layer will be described below.

(1) Intrinsic semiconductor

The material of the intrinsic semiconductor used may be, for example, a mixture formed by mixing a first material, which is formed of at least one of a fullerene, a fullerene derivative, carbon nanotubes (CNT) having semiconductivity and a CNT compound, and a second material, which is formed of a derivative of polyphenylenevinylene (PPV) or a polythiophene polymer material, in such a manner that the resulting semiconductor becomes an intrinsic semiconductor. The fullerene derivative used may be, for example, [6,6]-phenyl-C61-butyric acid methyl ester (PCBM), and a dimer of a fullerene, a fullerene compound containing an alkali metal, an alkaline earth metal or the like introduced, and the like may also be used. The CNT used may be carbon nanotubes intercalated with a fullerene or a metal-doped fullerene, or the like. A CNT compound having various molecules attached to the side wall or the tip of CNT, and the like may also be used.

The derivative of polyphenylenevinylene (PPV) used may be poly(2-methoxy-5-(2'-ethylhexyloxy)-p-phenylenevinylene (MEH-PPV) and the like, and the polythiophene polymer material used may be a poly(3-alkylthiophene), such as poly-3-hexylthiophene (P3HT); a dioctylfluorene-bithiophene copolymer (F8T2); and the like.

Particularly preferred examples of the intrinsic semiconductor include a mixture formed by mixing PCBM and P3HT at a mass ratio of from 1/0.3 to 1/4.

(2) p-Type semiconductor

Examples of the material of the p-type semiconductor include a polyalkylthiophene and a derivative thereof, polyphenylene and a derivative thereof, polyphenylenevinylene and a derivative thereof, polysilane and a derivative thereof, a polyalkylthiophene and a derivative thereof, a porphyrin derivative, a phthalocyanine derivative and an organic metal polymer and the like. Of those, a polyalkylthiophene and a derivative thereof are preferred. Mixtures of these organic materials may also be used. As the conductive polymer compound, poly-3,4-ethylenedioxythiophene/polystyrenesulfonate (PEDOT:PSS) may be preferably used. (3) n-Type semiconductor

The material of the n-type semiconductor is particularly preferably a fullerene derivative. The fullerene derivative used may be, for example, [6, 6] -phenyl-C61-butyric acid methyl ester (PCBM) and the like.

Examples of the method of forming the photoelectric conversion layer 4 on the conductive organic layer include a dry process, such as PVD (physical vapor deposition), e.g., vacuum vapor deposition, sputtering and ion plating, and CVD (chemical vapor deposition), e.g., thermal CVD and atomic layer deposition (ALD), and a coating method, e. g., dip coating, spin coating, spray coating, bar coating, gravure coating, die coating and doctor blade coating, which may be appropriately selected.

<Electrode>

The material of the electrode (which is denoted by numeral 6 in Fig. 4) preferably has a relatively small work function. Examples thereof include a metal, a metal oxide and an alloy, such as platinum, gold, aluminum, indium, chromium and zinc oxide, carbon nanotubes, and a composite of carbon nanotubes with the metal, metal oxide or alloy described above.

The thickness of the electrode is preferably from 20 nm  to 1 $\mu$m, and particularly preferably from 30 to 200 nm.

Examples of the method of forming the electrode on the photoelectric conversion layer (which is denoted by numeral 4 in Fig. 4) include a dry process, such as PVD (physical vapor deposition), e.g., vacuum vapor deposition, sputtering and ion plating, and CVD (chemical vapor deposition), e.g., thermal CVD and atomic layer deposition (ALD), and a wet process, such as a coating method, e.g., dip coating, spin coating, spray coating, bar coating, gravure coating, die coating and doctor blade coating, and electrochemical deposition, which may be appropriately selected depending on the material of the electrode.

In the organic thin film device of the present invention, the electrode (which is denoted by numeral 6 in Fig. 4) is preferably formed in such a manner that the electrode does not overlap the outer frame of the conductive metal pattern layer (see Fig. 5). With the structure, a short circuit due to contact of the electrode described later and the conductive pattern layer may be avoided.

The organic thin film device of the present invention may have a substrate layer laminated on the electrode depending on necessity.

Examples of the substrate generally include glass (plate) and a plastic film, which may be applied depending on the purpose of the organic thin film device. Examples of the  plastic film include films of polyethylene terephthalate, polyethylene naphthalate, tetraacetyl cellulose, syndiotactic polystyrene, polyphenylene sulfide, polycarbonate, polyarylate, polysulfone, polyestersulfone, polyetherimide and cyclic polyolefin, and ones excellent in mechanical strength, durability and the like are preferred.

Of those, ones having high transparency are preferred on applying to a photoelectric conversion or electrophoto conversion device.

The thickness of the substrate layer is preferably from 3 $\mu$m to 5 mm, more preferably from 5 $\mu$m to 1 mm, and particularly preferably from 10 to 300 $\mu$m, from the standpoint of the balance between mechanical strength and transparency.

Examples

The present invention will be described below in more detail with reference to Examples and Comparative Examples, but the present invention is not limited thereto.

<Example 1>

On an easy adhesion-processed surface of polyethylene terephthalate (Cosmoshine A4300, a trade name, produced by Toyobo Co., Ltd., thickness: 125 $\mu$m, hereinafter referred to as a PET film) as a transparent substrate, a copper layer was formed to have a thickness of 0.5 $\mu$m by a vacuum vapor deposition method. A photoresist was printed in a pattern shape on the copper layer by a screen printing method for patterning, and then the unnecessary portion of the copper layer was removed by an etching treatment, thereby forming a copper pattern layer in a mesh form having many rectangular apertures (lattice shape) arranged (pitch: 1.2 mm, line width: 30 $\mu$m, aperture ratio: 90%, copper layer thickness: 0.5 $\mu$m) as a conductive metal pattern layer [see Fig. 3 (a)]. The PET film having the copper pattern layer thus obtained was cut out to a sheet form of 25 mm $\times$ 24 mm. For forming a masked portion in a U-shape with a width of 5 mm along the three edges of the four edges of the sheet [see Fig. 3(c)], a toluene solution of polydimethylsiloxane (PDMS) (produced by Sigma-Aldrich, Inc.) was coated on the portion other than the U-shaped portion, thereby forming a mask with a PDMS film. Silver was vapor deposited on the sheet by a vacuum vapor deposition method, and then the PDMS film was removed, thereby forming a silver layer (thickness: 100 nm) in a U-shape having edge lengths of 25 mm, 24 mm and 25 mm respectively and a line width of 5 mm as a silver conductive metal pattern layer in a U-shape (aperture ratio: 80%).
It was confirmed that the shape of the resulting conductive metal pattern layer viewed from the surface thereof was a shape having a continuous outer frame, in which the outer frame was partly cut off [see Fig. 3(c)].
The conduction between the copper pattern layer and the silver layer was confirmed with a circuit tester.
Subsequently, the PET film having the conductive metal pattern layer was rinsed with a 1% by mass neutral detergent aqueous solution (Cica Clean LX II, a trade name, produced by Kanto Kagaku Co., Ltd.), pure water, acetone, pure water, 2-propanol, and pure water in this order for 10 minutes respectively under application of ultrasonic wave. The PET film was then immersed in 2-propanol and heated to boiling for 10 minutes. The PET film having the conductive metal pattern layer was dried and cleaned by subjecting to a treatment in a UV-ozone cleaner ["UV253E", a trade name, produced by Filgen, Inc.) for 30 minutes.
On the conductive metal pattern layer of the cleaned PET film having the conductive metal pattern layer, PEDOT:PSS ("HBS5", a trade name, produced by Agfa Materials Japan, Ltd.) was formed into a film by spin coating and heated with a hot plate to 150°C for 30 minutes, thereby forming a uniform coated film (conductive organic layer), and thus a transparent conductive laminate body was produced. The thickness of the conductive organic layer (PEDOT:PSS layer) after drying was 70 nm, when confirmed by a profilometer (Dektak 150, produced by Veeco Japan, Inc.).

<Example 2>

[Production of Organic thin film device]

The transparent conductive laminate body obtained in Example 1 was placed in a globe box replaced with dry nitrogen. On the surface of the transparent conductive laminate body having the conductive organic layer (PEDOT:PSS layer) formed thereon, a coating liquid containing 30 mg of poly-3-hexylthiophene (P3HT, "SP001", a product name, produced by Merck & Co., Inc.) and 22 mg of phenyl-C61-butyric acid methyl ester (PCBM, produced by Frontier Carbon Corporation) dissolved in dehydrated chlorobenzene (2.0 mL) was spin coated to form an organic layer. The resulting organic layer was heated with a hot plate in the globe box to form a photoelectric conversion layer. The thickness of the photoelectric conversion layer was 110 nm, when confirmed by a profilometer (the same as above). Subsequently, the laminate body was transferred to a vacuum vapor deposition machine without exposing to the air, and an aluminum layer (thickness: 100 nm, area: 0.55 cm$^2$) as an electrode was laminated through a mask at the degree of vacuum of 3 $\times$ 10$^{-4}$ Pa or less on the photoelectric conversion layer at a position that was not in contact with the silver layer of the conductive metal pattern layer, thereby providing an organic thin film device.

<Example 3>

A transparent conductive laminate body was produced in the same manner as in Example 1 except that copper was vapor deposited instead of silver in Example 1 to form a copper pattern in a U-shape.

<Example 4>

On an easy adhesion-processed surface of a PET film as in Example 1, a silver layer was formed to have a thickness of 0.25 $\mu$m by a vacuum vapor deposition method, and a copper layer was further formed on the silver layer to have a thickness of 0.25 $\mu$m by a vacuum vapor deposition method. Subsequently, a conductive metal pattern layer having a multilayer structure in a mesh form having many rectangular apertures (lattice shape) arranged (pitch: 1.2 mm,

line width: 30 μm, aperture ratio: 90%, silver layer thickness: 0.25 μ, copper layer thickness: 0.5 μm) [see Fig. 3(a)] was formed thereon in the same manner as in Example 1.

Subsequently, a silver pattern layer in a U-shape was formed in the same manner as in Example 1, thereby producing a transparent conductive laminate body.

<Comparative Example 1>

A comparative transparent conductive laminate body was produced in the same manner as in Example 1 except that magnesium was vapor deposited instead of copper to form a magnesium pattern layer in a mesh form, and magnesium was vapor deposited instead of silver to form a magnesium pattern layer in a U-shape.

<Comparative Example 2>

A transparent conductive laminate body was produced in the same manner as in Example 1 except that the conductive metal pattern layer was not formed. Specifically, PEDOT:PSS ("HBS5", a trade name, produced by Agfa Materials Japan, Ltd.) was formed into a film on the PET film by spin coating in atmosphere and heated with a hot plate to 150°C for 30 minutes, thereby forming a uniform coated film (conductive organic layer), and thus a transparent conductive laminate body was produced. The thickness of the conductive organic layer (PEDOT:PSS layer) after drying was 70 nm, when confirmed by a profilometer (Dektak 150, produced by Veeco Japan, Inc.).

<Comparative Example 3>

An organic thin film device was produced in the same manner as in Example 2 except that the transparent conductive laminate body obtained in Comparative Example 2 was used.

The transparent conductive laminate bodies obtained in Examples 1, 3 and 4 and Comparative Examples 1 and 2 were measured for the substrate characteristics, i.e., the total luminous transmittance and the surface resistivity, and the current-voltage characteristics of the organic thin film devices in the following manners.

(Total luminous transmittance)

The total luminous transmittance of the transparent conductive laminate body was measured with "NHD-5000", a product name, produced by Nippon Denshoku Industries Co. , Ltd., according to the method of JIS K7361-1.

(Surface Resistivity)

The surface of the conductive organic layer of the transparent conductive laminate body was measured for the surface resistivity with Loresta GP MCP-T600, produced by Mitsubishi Chemical Corporation, by a four-terminal method.

(Current-Voltage characteristics)

The organic thin film devices obtained in Example 2 and Comparative Example 3 were measured for the current-voltage characteristics in such a manner that the device was measured with a solar simulator (WXS-50S-1.5, produced by Wacom Electric Co., Ltd.) and a voltage-current source/monitor (R6243, produced by ADC Corporation), and a photoelectric conversion efficiency was determined from the resulting measured values with a measurement software (W32-R3244SOL, produced by Systemhouse Sunrise Corporation). The effective area of the device was 0.55 cm$^2$. Table 1 collectively shows the characteristics of the transparent conductive laminate bodies obtained in Examples 1 and 3 and the organic thin film device obtained in Example 2.

Table 1

| | Conductive metal pattern layer | | Substrate characteristics | | Photoelectric conversion efficiency (%) |
|---|---|---|---|---|---|
| | Thickness | Presence of shape with continuous outer frame | Total luminous transmittance (%) | Surface resistivity (Ω per square) | |
| Example 1 | copper layer 0.5 μm | present (material: silver) | 91 | 150 | - |
| Example 2 | copper layer 0.5 μm | present (material: silver) | 91 | 150 | 0.61 |
| Example 3 | copper layer 0.5 μm | present (material: copper) | 91 | 149 | - |
| Example 4 | silver layer 0.25 μm / copper layer 0.25 μm | present (material: silver) | 91 | 148 | - |
| Comparative Example 1 | magnesium layer 0.5 μm | present (material: magnesium) | 85 | 500 | - |
| Comparative Example 2 | none | none | 100 | 700 | - |
| Comparative Example 3 | none | none | 100 | 700 | 0.08 |

It was confirmed from the results shown in Table 1 that the transparent conductive laminate bodies of the present invention prepared in Examples 1, 3 and 4 have a low surface resistivity, have conductivity capable of being applied to an electrode for a device, have a high total luminous transmittance of 90% or more, and thus are useful as a transparent conductive laminate body, in spite of the absence of ITO. It was also confirmed that the organic thin film device of the present invention prepared in Example 2 having the transparent conductive laminate body of the present invention prepared in Example 1 functions as a photoelectric conversion device in spite of the absence of ITO.
On the other hand, it was confirmed that the transparent conductive laminate body prepared in Comparative Example 1 has a low total luminous transmittance, thus is inferior in transparency, has a high surface resistivity, and thus is inferior in conductivity, as compared to those prepared in Examples 1 to 4.

Industrial Applicability

The transparent conductive laminate body of the present invention can be applied to an organic thin film device, such as an organic device, e.g., an organic transistor, an organic  memory device and an organic EL device; a liquid crystal display device; electronic paper; a thin film transistor; an electrochromic device; an electrochemical light emitting device; a touch-sensitive panel; a display device; a photoelectric conversion device, such as a solar cell; a thermoelectric conversion device; a piezoelectric conversion device; and a capacitor device, due to the low surface resistivity and the high transparency, and thus is useful in various fields of electronic devices.

Description of Symbols

1:    transparent substrate
2:    conductive metal pattern layer
3:    conductive organic layer
4:    transparent conductive laminate body:
5:    photoelectric conversion layer
6:    electrode

7: organic thin film device

**Claims**

1. A transparent conductive laminate body wherein a conductive metal pattern layer and a conductive organic layer containing a conductive organic polymer compound are in this order laminated directly on at least one surface of a transparent substrate, **characterized in that** a material for forming the conductive metal pattern layer is at least one metal selected from gold, silver, copper and platinum, or an alloy containing the metal.

2. The transparent conductive laminate body according to claim 1, wherein the conductive organic polymer compound is at least one selected from a polyaniline, a polypyrrole, a polythiophene, and derivatives thereof.

3. The transparent conductive laminate body according to claim 1 or 2, wherein the conductive metal pattern layer has a shape, as viewed from a surface thereof, that has a continuous outer frame.

4. The transparent conductive laminate body according to claim 3, wherein the outer frame is partly cut off.

5. An organic thin film device comprising the transparent conductive laminate body according to any one of claims 1 to 4.

Figure 1

Figure 2

(a)                    (b)                    (c)

(d)                    (e)                    (f)

Figure 3

(a)                    (b)                    (c)

Figure 4

Figure 5

14

## INTERNATIONAL SEARCH REPORT

| | International application No. |
|---|---|
| | PCT/JP2011/077435 |

A. CLASSIFICATION OF SUBJECT MATTER
*H01B5/14*(2006.01)i, *B32B15/08*(2006.01)i, *H01L51/42*(2006.01)i, *H01L51/50* (2006.01)i, *H05B33/28*(2006.01)i

According to International Patent Classification (IPC) or to both national classification and IPC

B. FIELDS SEARCHED

Minimum documentation searched (classification system followed by classification symbols)
H01B5/14, B32B15/08, H01L51/42, H01L51/50, H05B33/28

Documentation searched other than minimum documentation to the extent that such documents are included in the fields searched
| Jitsuyo Shinan Koho | 1922-1996 | Jitsuyo Shinan Toroku Koho | 1996-2012 |
| Kokai Jitsuyo Shinan Koho | 1971-2012 | Toroku Jitsuyo Shinan Koho | 1994-2012 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X | JP 2008-66212 A (Toray Industries, Inc.), 21 March 2008 (21.03.2008), claims; paragraphs [0034], [0047]; fig. 1 (Family: none) | 1-5 |
| X | JP 2008-226753 A (Toray Industries, Inc.), 25 September 2008 (25.09.2008), claims; paragraphs [0030], [0048]; fig. 1 (Family: none) | 1-5 |
| X | WO 2010/050318 A1 (Konica Minolta Holdings, Inc.), 06 May 2010 (06.05.2010), claims; paragraphs [0028] to [0034]; fig. 1 (Family: none) | 1-5 |

☒ Further documents are listed in the continuation of Box C.    ☐ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 30 January, 2012 (30.01.12) | 07 February, 2012 (07.02.12) |

| Name and mailing address of the ISA/ | Authorized officer |
|---|---|
| Japanese Patent Office | |
| Facsimile No. | Telephone No. |

Form PCT/ISA/210 (second sheet) (July 2009)

**INTERNATIONAL SEARCH REPORT**

International application No.

PCT/JP2011/077435

C (Continuation).  DOCUMENTS CONSIDERED TO BE RELEVANT

| Category* | Citation of document, with indication, where appropriate, of the relevant passages | Relevant to claim No. |
|---|---|---|
| X | WO 2010/082428 A1  (Konica Minolta Holdings, Inc.), 22 July 2010 (22.07.2010), claims; paragraphs [0048] to [0054], [0098] (Family: none) | 1-5 |
| X | JP 2010-205532 A  (Konica Minolta Holdings, Inc.), 16 September 2010 (16.09.2010), claims; paragraphs [0059] to [0062], [0093] to [0095] (Family: none) | 1-5 |

Form PCT/ISA/210 (continuation of second sheet) (July 2009)

**EP 2 662 865 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- WO 2005041216 A
- JP 2008204683 A
- JP 2008288102 A
- JP 2005302508 A
- JP 2009081104 A
- JP 2009146678 A